# EUROPEAN PATENT SPECIFICATION

(11) **EP 4 600 679 B1**
(45) Date of publication and mention of the grant of the patent: **16.09.2026**
(21) Application number: 25156416.7
(22) Date of filing: 07.02.2025
(51) Int. Cl.: G01R 31/392, G01R 31/396

(54) **APPARATUS AND METHOD FOR DIAGNOSING BATTERY ASSEMBLY**
VORRICHTUNG UND VERFAHREN ZUR DIAGNOSE EINER BATTERIEANORDNUNG
APPAREIL ET PROCÉDÉ DE DIAGNOSTIC D'UN ENSEMBLE BATTERIE

(30) Priority: 08.02.2024 KR 20240019807
(43) Date of publication of application: 13.08.2025
(73) Proprietor: LG Energy Solution, Ltd., Seoul 07335 (KR)
(72) Inventor: KIM, Se-Ram, 34122 Daejeon (KR); KIM, Ju-Ri, 34122 Daejeon (KR); BAE, Yoon-Jung, 34122 Daejeon (KR); JEONG, Hee-Seok, 34122 Daejeon (KR)
(74) Representative: Goddar, Heinz J.

(56) References cited:
- WO-A1-2021/186550
- KR-B1- 101 930 646
- US-A1- 2024 012 058

## Description

### CROSS-REFERENCE TO RELATED APPLICATIONS

This application is based on and claims priority from Korean Patent Application No. 10-2024-0019807, filed on February 8, 2024, with the Korean Intellectual Property Office.

### TECHNICAL FIELD

The present disclosure relates to an apparatus and method for diagnosing a battery assembly, and more particularly, to an apparatus and method for non-destructively diagnosing a state of a battery assembly capable of charging and discharging.

### BACKGROUND

Recently, the demand for portable electronic products such as notebook computers, digital cameras and portable telephones has increased sharply, and electric vehicles, energy storage systems, robots, satellites and the like have been developed in earnest. Accordingly, high-performance batteries allowing charging and discharging and having a high energy density are being actively studied.

Types of rechargeable batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

The positive electrode and negative electrode of these batteries gradually deteriorate as the charge and discharge cycles are repeated, and they no longer maintain the electrical capacity they had at the time of manufacture but are deteriorated. Therefore, in order to accurately predict the usable time, remaining life, and replacement time of the battery, an accurate diagnosis of the battery state is required.

However, in diagnosing the battery assembly (e.g., battery module or battery pack) that includes a plurality of battery cells corresponding to the basic units of charge and discharge, the existing technologies perform diagnosis based on the SOH (State of Health) of the corresponding battery assembly. Therefore, when the battery assembly includes a plurality of battery banks that are provided by connecting a plurality of battery cells in parallel with each other, the existing technologies have a problem in that they cannot diagnose the state of the corresponding battery assembly for each battery bank, and cannot diagnose whether the battery cells of each battery bank are deteriorated unevenly.
WO 2021/186550 A1 describes a secondary battery control device and method, in which, given that X represents a value corresponding to a capacity difference between a first specific peak, or a mathematically equivalent point thereto, among multiple extremum points on a first-order differential curve obtained by differentiating a Q-V curve of a secondary battery with respect to voltage and a second specific peak, or a mathematically equivalent point thereto, among multiple extremum points on second-order differential curves obtained by differentiating the Q-V curve of the secondary battery with respect to capacity and with respect to voltage, and A and B represent constants obtained in advance from the relation between the X in a calibration sample and a degree of deterioration of the calibration sample, this secondary battery control device corrects the degree of deterioration SOH of the secondary battery to (1): SOH=AX+B. A battery pack equipped with this secondary battery control device has high safety, is useful for stable supply of energy, and contributes to sustainable development goals.

### SUMMARY

Aspects of the present disclosure are designed to at least partly address, and even solve, the problems of the related art, and therefore the present disclosure is directed to providing an apparatus and method for diagnosing a battery assembly, which may diagnose the state of a battery assembly including a plurality of battery banks, which are formed by connecting a plurality of battery cells in parallel, for each battery bank, and may diagnose whether the battery cells of each battery bank have deteriorated unevenly.

Another technical challenge that aspects of the present disclosure seek to address is to provide an apparatus and method for diagnosing a battery that may extend the life of a battery assembly and improve safety.

A method for diagnosing a battery assembly according to one aspect of the present disclosure diagnoses a battery assembly including a battery bank comprising a plurality of battery cells connected in parallel with each other, and the method comprises generating a second differential profile representing a relationship between a second differential capacity, which is obtained by taking a second derivative of a capacity of the battery bank with respect to a voltage of the battery bank, and the voltage of the battery bank; and detecting a target peak located in a predetermined voltage section among a plurality of peaks of the second differential profile and diagnosing a state of the battery bank based on a second differential capacity value of the target peak.

In an embodiment, the generating the second differential profile may include a step of repeatedly measuring a voltage value and a current value of the battery bank using at least one electrical sensor while the battery bank is being charged or discharged; and generating the second differential profile using the voltage values and the current values measured while the battery bank is being charged or discharged.

In an embodiment, generating the second differential profile may include generating a profile representing the relationship between the voltage and the capacity of the battery bank; generating a first differential profile by differentiating the profile with respect to the voltage of the battery bank; and generating the second differential profile by differentiating the first differential profile with respect to the voltage of the battery bank.

In an embodiment, diagnosing the state of the battery bank may include comparing the second differential capacity value of the target peak with a predetermined threshold value, and diagnosing the state of the battery bank as an abnormal state when the second differential capacity value is less than a threshold value.

In an embodiment, diagnosing the state of the battery bank may include diagnosing the state of the battery bank as an abnormal state in which the plurality of battery cells are unevenly deteriorated, when the second differential capacity value of the target peak is less than a predetermined threshold value and the number of peaks located in the predetermined voltage section exceeds a predetermined reference number.

In an embodiment, the battery assembly may include a plurality of battery banks, the method may further comprise generating a plurality of second differential profiles respectively corresponding to the plurality of battery banks included in the battery assembly, and diagnosing a state of each of the plurality of battery banks as a normal state or an abnormal state based on the plurality of second differential profiles.

In an embodiment, diagnosing that state of the battery bank may include diagnosing the state of the battery bank as an abnormal state when the second differential capacity value of the target peak is less than a predetermined threshold value, and the method for diagnosing the battery may further comprise controlling a charger that charges the battery bank to reduce a voltage at an end of charging of the battery bank or reduce a current rate of a current that charges the battery bank, when the state of the battery bank is diagnosed as an abnormal state.

An apparatus for diagnosing a battery assembly according to another aspect of the present disclosure diagnoses a battery assembly including a battery bank provided by connecting a plurality of battery cells in parallel with each other, and the apparatus comprises a second differential profile generating unit configured to generate a second differential profile representing a relationship between a second differential capacity, which is obtained by taking a second derivative of a capacity of the battery bank with respect to a voltage of the battery bank, and the voltage of the battery bank; and a diagnosing unit configured to detect a target peak located in a predetermined voltage section among a plurality of peaks of the second differential profile and diagnose a state of the battery bank based on a second differential capacity value of the target peak.

In an embodiment, the diagnosing unit may be configured to compare the second differential capacity value of the target peak with a predetermined threshold value, and diagnose the state of the battery bank as an abnormal state when the second differential capacity value is less than a threshold value.

In an embodiment, the diagnosing unit may be configured to diagnose the state of the battery bank as an abnormal state in which the plurality of battery cells are unevenly deteriorated, when the second differential capacity value of the target peak is less than a predetermined threshold value and the number of peaks located in the predetermined voltage section exceeds a predetermined reference number.

In an embodiment, the battery assembly may include a plurality of battery banks, the second differential profile generating unit may be configured to generate a plurality of second differential profiles respectively corresponding to the plurality of battery banks included in the battery assembly, and the diagnosing unit may be configured to diagnose a state of each of the plurality of battery banks as a normal state or an abnormal state based on the plurality of second differential profiles.

In an embodiment, the diagnosing unit may be configured to diagnose the state of the battery bank as an abnormal state when the second differential capacity value of the target peak is less than a predetermined threshold value, and the apparatus for diagnosing a battery may further comprise a battery management unit configured to control a charger that charges the battery bank to reduce a voltage at an end of charging of the battery bank or reduce a current rate of a current that charges the battery bank, when the state of the battery bank is diagnosed as an abnormal state.

A battery pack according to still another aspect of the present disclosure may comprise the apparatus for diagnosing a battery as described above.

A vehicle according to still another aspect of the present disclosure may comprise the apparatus for diagnosing a battery as described above.

In some examples, the method as disclosed herein may be carried out using the apparatus as disclosed herein. Accordingly, the features described herein in connection with the apparatus may also be applicable to the method, unless indicated otherwise or technically inappropriate. Additionally or alternatively, the apparatus as disclosed herein may be configured to perform the method as disclosed herein. Accordingly, the features described herein in connection with the method may also be applicable to the apparatus, unless indicated otherwise or technically inappropriate.

Embodiments of the present disclosure diagnose the state of a battery bank by using the second differential profile, which represents the relationship between the second differential capacity, which is obtained by taking a second derivative of the battery bank included in the battery assembly with respect to the voltage of the battery bank, and the voltage of the battery bank, thereby enabling the diagnosis of the state of the battery assembly including a plurality of battery banks for each battery bank, and improving the accuracy and reliability of the diagnosis result.

In addition, embodiments of the present disclosure may accurately diagnose whether the battery cells are deteriorated unevenly in a battery bank that is formed by connecting the battery cells in parallel by diagnosing the state of the battery bank based on the second differential capacity value of a target peak located in a predetermined voltage section among a plurality of peaks of the second differential profile.

In addition, embodiments of the present disclosure may perform management of a battery assembly including a plurality of battery banks for each battery bank by controlling the charge and/or discharge conditions of the corresponding battery bank according to the diagnosis result of the battery bank, thereby extending the life of the entire battery assembly and improving safety.

Furthermore, a person having ordinary skill in the art to which the present disclosure belongs will be able to clearly understand from the following description that various embodiments according to the present disclosure can solve various technical problems not mentioned above.

### DESCRIPTION OF DRAWINGS

FIG. 1 is a block diagram showing an apparatus for diagnosing a battery assembly according to an embodiment of the present disclosure.
FIG. 2 is a drawing showing an example of a battery assembly to be diagnosed according to the present disclosure.
FIG. 3 is a drawing showing an example of a profile showing the relationship between the capacity and voltage of a battery bank.
FIG. 4 is a drawing showing an example of a first differential profile of a normal battery bank.
FIG. 5 is a drawing showing an example of a second differential profile of a normal battery bank.
FIG. 6 is a drawing showing an example of a first differential profile of an abnormal battery bank.
FIG. 7 is a drawing showing an example of second differential profile of an abnormal battery bank.
FIG. 8 is a graph showing an example of the change in the second differential capacity value of a first target peak according to the uneven deterioration of the battery bank.
FIG. 9 is a graph showing an example of the change in the second differential capacity value of a second target peak according to the uneven deterioration of the battery bank.
FIG. 10 is a flow chart showing a method for diagnosing a battery assembly according to an embodiment of the present disclosure.
FIG. 11 is a drawing showing a battery pack according to an embodiment of the present disclosure.
FIG. 12 is a drawing showing a vehicle according to an embodiment of the present disclosure.

### DETAILED DESCRIPTION

Hereinafter, in order to clarify one or more solutions corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted. In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

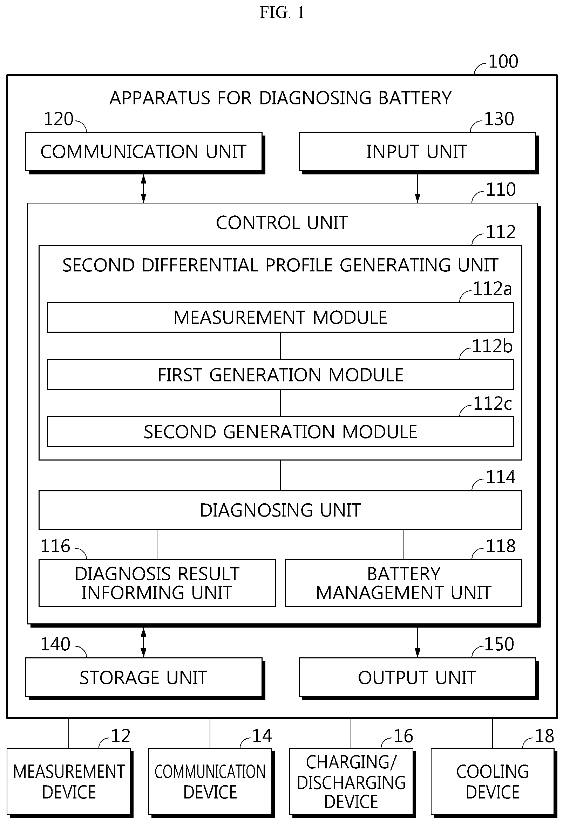

FIG. 1 is a block diagram showing an apparatus 100 for diagnosing a battery assembly according to an embodiment of the present disclosure.

As illustrated in FIG. 1, the apparatus 100 for diagnosing a battery assembly according to an embodiment of the present disclosure includes a control unit 110. The control unit 110 is configured to non-destructively diagnose a battery assembly including one or more battery banks formed by connecting a plurality of rechargeable battery cells in parallel.

To this end, the control unit 110 may include one or more general-purpose processors or ASICs (application-specific integrated circuits) for executing the battery diagnosis logic, and may optionally further include hardware such as registers and memories according to an embodiment. The control unit 110 may be configured with a combination of hardware such as a processor and software such as a computer program. That is, the battery diagnosis logic of the control unit 110 may be configured as a computer program and stored in the memory of the control unit 110 or a storage unit 140 described below, and the stored computer program may be configured to be executed through the hardware of the control unit 110.

Meanwhile, the control unit 110 is a detailed component for diagnosing the battery assembly and includes a second differential profile generating unit 112 and a diagnosing unit 114.

The second differential profile generating unit 112 is configured to generate a second differential profile representing the relationship between the second differential capacity, which is obtained by taking a second derivative of the capacity of a battery bank included in a battery assembly with respect to the voltage of the battery bank, and the voltage of the battery bank.

In an embodiment, the second differential profile generating unit 112 may include a measurement module 112a, a first generation module 112b, and a second generation module 112c.

In this case, the measurement module 112a may be configured to repeatedly measure the voltage value and current value of the battery bank using at least one electrical sensor while the battery bank is being charged or discharged.

The first generation module 112b and the second generation module 112c may generate the second differential profile using the voltage values and current values measured by the measurement module 112a while the battery bank is being charged or discharged.

For example, the first generation module 112b may be configured to generate a profile representing the relationship between the voltage and capacity of the battery bank using voltage values and current values measured while the battery bank is being charged or discharged.

The second generation module 112c may be configured to generate a first differential profile by differentiating the generated profile with respect to the voltage of the battery bank, and to generate the second differential profile by differentiating the first differential profile with respect to the voltage of the battery bank.

The diagnosing unit 114 is configured to detect a target peak located in a predetermined voltage section among a plurality of peaks of the second differential profile, and diagnose the state of the battery bank based on the second differential capacity value of the target peak.

The voltage section where the target peak is located may be experimentally determined. That is, the voltage section where the peak where splitting occurs due to uneven degradation of the battery bank among the peaks of the second differential profile is located may be experimentally confirmed, and the confirmed voltage section may be determined as the voltage section where the target peak is located.

In an embodiment, the diagnosing unit 114 may be configured to compare the second differential capacity value of the target peak with a predetermined threshold value, and to diagnose the state of the battery bank as an abnormal state if the second differential capacity value is less than the threshold value. In this case, the abnormal state may mean a state in which a plurality of battery cells forming the battery bank are unevenly deteriorated.

The threshold value may be the minimum value among the second differential capacity values that the target peak of the normal battery bank may have, or a value determined during the design of the battery assembly.

In another embodiment, the diagnosing unit 114 may be configured to diagnose the state of the battery bank as an abnormal state if the second differential capacity value of the target peak is less than a predetermined threshold value and the number of peaks located in the predetermined voltage section exceeds a predetermined reference number. In this case, the abnormal state may mean a state in which a plurality of battery cells forming the battery bank are unevenly deteriorated.

In another embodiment, the diagnosing unit 114 may be configured to determine the state of the battery bank based on a plurality of target peaks.

In this case, the diagnosing unit 114 may be configured to detect a first target peak located in a first voltage section and a second target peak located in a second voltage section among predetermined voltage sections.

And, the diagnosing unit 114 may be configured to determine the state of the battery bank as an abnormal state if the second differential capacity value of the first target peak is less than a predetermined first threshold value and the second differential capacity value of the second target peak is less than a predetermined second threshold value. In this case, the abnormal state may mean a state in which a plurality of battery cells included in the battery bank are unevenly deteriorated.

In an embodiment, when the battery assembly to be diagnosed includes a plurality of battery banks, the second differential profile generating unit 112 may be configured to generate a plurality of second differential profiles respectively corresponding to the plurality of battery banks.

In this case, the diagnosing unit 114 may be configured to diagnose the state of each of the plurality of battery banks as a normal state or an abnormal state based on the plurality of second differential profiles.

In an embodiment, the control unit 110 may further include a diagnosis result informing unit 116. In this case, the diagnosis result informing unit 116 may be configured to output a visual, auditory or audio-visual notification signal corresponding to the diagnosis result of the battery bank using a predetermined output device.

In an embodiment, the control unit 110 may further include a battery management unit 118. In this case, the battery management unit 118 may be configured to control a charging condition and/or a discharging condition of the battery bank according to the diagnosis result for the battery bank.

For example, when an abnormal battery bank diagnosed as an abnormal state is detected by the diagnosing unit 114 among the plurality of battery banks included in the battery assembly, the battery management unit 118 may be configured to control a charger that charges the abnormal battery bank to reduce a voltage at the end of charging of the abnormal battery bank or reduce a current rate of a current that charges the abnormal battery bank.

Meanwhile, the battery management unit 118 may be configured to control the cooling device 18 described later to lower the temperature of an abnormal battery bank.

The second differential profile generating unit 112, the diagnosing unit 114, the diagnosis result informing unit 116, and the battery management unit 118 of the above-described control unit 110 may be implemented as a combination of a processor and a program executed by the processor. In this case, the control unit 110 may be implemented as a single processor, or may be implemented as two or more processors that are interconnected.

In an embodiment, the apparatus 100 for diagnosing a battery may further include a communication unit 120. The communication unit 120 may be configured to receive data transmitted from a remotely located server or communication terminal via a wired and/or wireless communication network and transmit the data to the control unit 110, or transmit control signals, diagnostic data, etc. processed by the control unit 110 to the remotely located server or communication terminal. To this end, the communication unit 120 may include a communication modem that performs wired and/or wireless communication.

In an embodiment, the apparatus 100 for diagnosing a battery may further include an input unit 130. The input unit 130 may be configured to receive commands or data from a user or an administrator. For this purpose, the input unit 130 may include an input device such as a keyboard, operating buttons, or a touch panel.

In an embodiment, the apparatus 100 for diagnosing a battery may further include a storage unit 140. The storage unit 140 may be configured to store and manage data required for the operation of the apparatus 100 for diagnosing a battery. To this end, the storage unit 140 may include one or two or more of a ROM, a RAM, an EEPROM, a register, a flash memory, a CD-ROM, a magnetic tape, a hard disk, a floppy disk, and an optical data recording device.

In an embodiment, the apparatus 100 for diagnosing a battery may further include an output unit 150. The output unit 150 may be configured to visually, audibly or audiovisually output a notification signal of the diagnosis result informing unit 116. For this purpose, the output unit 150 may include a visual output device such as a light-emitting diode, a monitor, a display panel or a touch screen. In addition, the output unit 150 may further include a sound generating device such as a speaker.

In an embodiment, the apparatus 100 for diagnosing a battery may be configured to be interlocked with a measurement device 12 for measuring voltage and/or current of a battery assembly to be diagnosed, a communication device 14 for communicating with another device, a charging/discharging device 16 for charging and discharging battery banks included in the battery assembly, a cooling device 18 for cooling the battery banks included in the battery assembly, etc.

In another embodiment, the apparatus 100 for diagnosing a battery according to the present disclosure may include one or more of the measurement device 12, the communication device 14, the charging/discharging device 16, and the cooling device 18 described above.

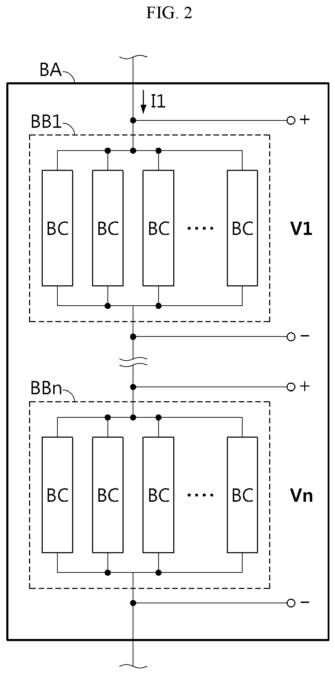

FIG. 2 is a drawing showing an example of a battery assembly BA to be diagnosed according to the present disclosure.

As illustrated in FIG. 2, the battery assembly BA, which is the diagnostic target of the present disclosure, may include a plurality of battery banks BB1 to BBn. In this case, the plurality of battery banks BB1 to BBn may be connected in series with each other, or may be connected in a manner that mixes series and parallel connections. In addition, each battery bank may include a plurality of battery cells BC that are connected in parallel with each other.

Such a battery assembly BA may be implemented as a battery module or a battery pack including battery banks and a case that accommodates the battery banks.

In this way, since the plurality of battery cells BC included in each battery bank are connected in parallel with each other, it is difficult to measure the voltage of each battery cell. Therefore, the existing technology that estimates the SOC or SOH of the battery assembly by using the voltage, current, temperature, etc. of the entire battery assembly as parameters may not be able to diagnose the state of the battery assembly for each battery bank, and may not be able to determine whether the battery cells of the above-mentioned battery bank are deteriorated unevenly.

On the other hand, the apparatus 100 for diagnosing the battery assembly according to aspects of the present disclosure measures the voltage (V1) and current (I1) of the battery bank BB1 while the battery bank BB1 is being charged or discharged, generates a profile representing the relationship between the voltage and capacity of the battery bank BB1, and uses a second differential profile obtained by taking a second derivative of this profile to diagnose the state of the battery bank, thereby making it possible to diagnose the state of the battery assembly for each battery bank and accurately determine whether the battery cells of the battery bank have deteriorated unevenly.

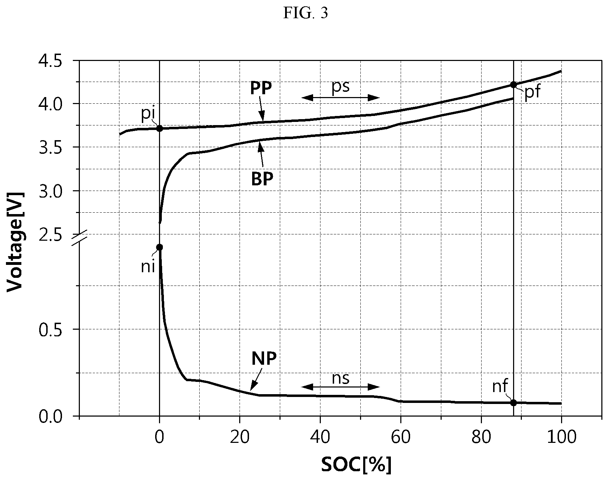

FIG. 3 is a drawing showing an example of a profile showing the relationship between the capacity and voltage of a battery bank.

As illustrated in FIG. 3, the second differential profile generating unit 112 may generate a profile BP representing a relationship between the capacity and voltage of the battery bank BB1 by measuring electrical values (V1, I1) of the battery bank BB1 while the battery bank BB1 of FIG. 2 is being charged or discharged. In this case, the capacity of the battery bank may be expressed as a SOC (State of Charge) value using a unit of percentage (%). For reference, the electric capacity possessed by the battery bank BB1 may be calculated by applying a current integration method to the current (I1) that charges the battery bank BB1.

Meanwhile, the second differential profile generating unit 112 may find the positive electrode profile PP and the negative electrode profile NP which generate a curve similar to the profile BP by mutual combination, and provide the start point (pi) and the end point (pf) of the positive electrode profile PP, the shrinkage ratio (ps) of the positive electrode profile PP compared with the reference positive electrode profile, the start point (ni) and the end point (nf) of the negative electrode profile NP, the shrinkage ratio (ns) of the negative electrode profile NP compared with the reference negative electrode profile, etc., to the diagnosing unit 114. The diagnosing unit 114 may use the start point (pi), the end point (pf) and the shrinkage ratio (ps) of the positive electrode profile PP, and the start point (ni), the end point (nf) and the shrinkage ratio (ns) of the negative electrode profile NP as diagnostic factors indicating the state of the battery bank BB1.

In addition, the second differential profile generating unit 112 may generate the second differential profile by taking a second derivative of the profile BP with respect to the voltage of the battery.

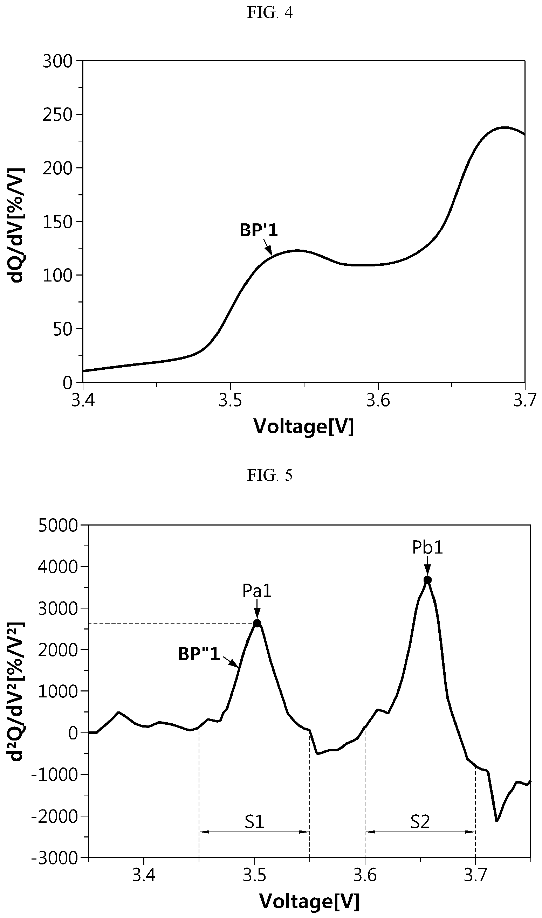

FIG. 4 is a drawing showing a first differential profile BP'1 of a normal battery bank.

As illustrated in FIG. 4, the second differential profile generating unit 112 may generate a first differential profile BP'1 by differentiating the profile representing the relationship between the voltage and capacity of the battery bank charged at a current rate of 0.33 [C] with respect to the voltage of the battery bank.

And, the second differential profile generating unit 112 may generate the second differential profile by differentiating the first differential profile BP'1 again with respect to the voltage of the battery bank.

FIG. 5 is a drawing showing a second differential profile BP"1 of a normal battery bank.

As illustrated in FIG. 5, the second differential profile generating unit 112 may generate a second differential profile BP"1 representing the relationship between the second differential capacity (d²Q/dV²), which is the second derivative of the capacity of the battery bank with respect to the voltage of the battery bank, and the voltage of the battery bank, for each battery bank at a predetermined diagnostic cycle.

Then, the diagnosing unit 114 may diagnose the state of the battery bank based on the second differential capacity value of the target peak (Pa1) located in the predetermined voltage section (S1) among the plurality of peaks of the second differential profile BP"1. For example, the voltage section (S1) may be a section from 3.45 [V] to 3.55 [V].

For example, if the second differential capacity value of the target peak (Pa1) is less than a predetermined threshold value, the diagnosing unit 114 may diagnose the state of the battery bank as an abnormal state. In this case, the abnormal state may mean a state in which the plurality of battery cells forming the battery bank are unevenly deteriorated.

The threshold value may be the minimum value among the second differential capacity values that the target peak of the normal battery bank can have, or a value determined during the design of the battery assembly.

In an embodiment, the diagnosing unit 114 may be configured to determine the state of the battery bank based on a plurality of target peaks.

In this case, the diagnosing unit 114 may detect a first target peak (Pa1) located in a first voltage section (S1) among predetermined voltage sections, and a second target peak (Pb1) located in a second voltage section (S2). For example, the first voltage section (S1) may be a section from 3.45 [V] to 3.55 [V], and the second voltage section (S2) may be a section from 3.60 [V] to 3.70 [V].

Next, the diagnosing unit 114 may determine the state of the battery bank as an abnormal state if the second differential capacity value of the first target peak (Pa1) is less than a predetermined first threshold value and the second differential capacity value of the second target peak (Pb1) is less than a predetermined second threshold value. The abnormal state may mean a state in which the plurality of battery cells of the battery bank are unevenly deteriorated.

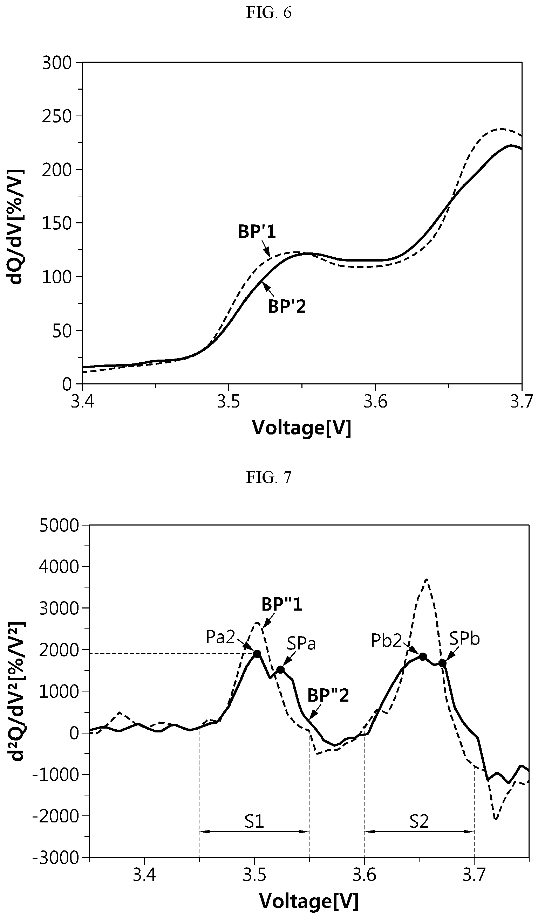

FIG. 6 is a drawing showing a first differential profile BP'2 of an abnormal battery bank.

As illustrated in FIG. 6, the first differential profile BP'2 of the abnormal battery bank in which battery cells are unevenly deteriorated shows a different pattern from the first differential profile BP'1 of the normal battery bank illustrated in FIG. 4. That is, the first differential profile BP'2 of the abnormal battery bank has a reduced slope change compared to the first differential profile BP'1 of the normal battery bank.

FIG. 7 is a drawing showing a second differential profile BP"2 of an abnormal battery bank.

As illustrated in FIG. 7, the second differential capacity value of the first target peak (Pa2) in the second differential profile BP"2 of an abnormal battery bank in which the battery cells are unevenly deteriorated is reduced compared to the second differential capacity value of the first target peak (Pa1) in the second differential profile BP"1 of a normal battery bank.

Similarly, the second differential capacity value of the second target peak (Pb2) appearing in the second differential profile BP"2 of the abnormal battery bank is reduced compared to the second differential capacity value of the second target peak (Pb1) appearing in the second differential profile BP"1 of the normal battery bank.

Therefore, the diagnosing unit 114 may determine the state of the battery bank as an abnormal state if the second differential capacity value of the first target peak (Pa2) is less than a predetermined first threshold value.

In another embodiment, the diagnosing unit 114 may determine the state of the battery bank as an abnormal state if the second differential capacity value of the first target peak (Pa2) is less than the first threshold value and the second differential capacity value of the second target peak (Pb2) is less than a predetermined second threshold value. In this case, the abnormal state may mean a state in which the plurality of battery cells of the battery bank are unevenly deteriorated.

Meanwhile, additional peaks (SPa, SPb) may occur around the first target peak (Pa2) and the second target peak (Pb2) of the second differential profile BP"2 of the abnormal battery bank due to the peak splitting phenomenon caused by uneven deterioration of the battery bank.

Therefore, the diagnosing unit 114 may diagnose the state of the battery bank as an abnormal state if at least one of the second differential capacity value of the first target peak (Pa2) and the second differential capacity value of the second target peak (Pb2) is less than a predetermined threshold value and the number of peaks located in the predetermined voltage section (S1, S2) exceeds a predetermined reference number. In this case, the abnormal state may mean a state in which the plurality of battery cells of the battery bank are unevenly deteriorated.

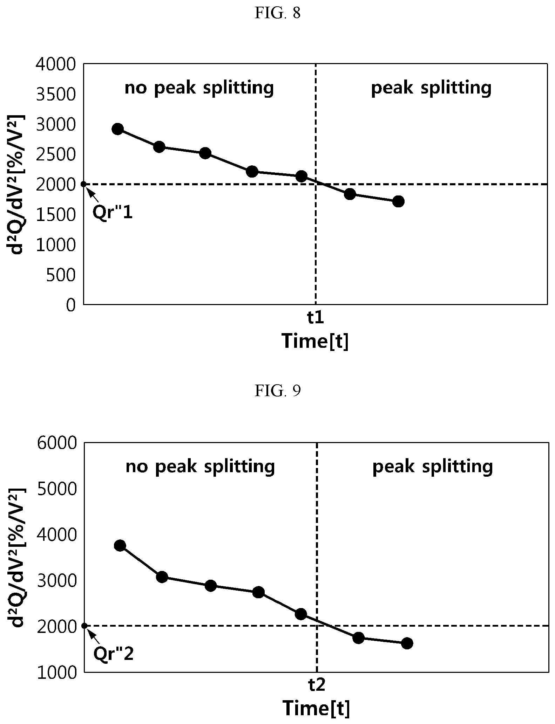

FIG. 8 is a graph showing the change in the second differential capacity value of a first target peak (Pa2) according to the uneven deterioration of the battery bank.

As shown in FIG. 8, when the battery cells of the battery bank are deteriorated unevenly, the second differential capacity value of the first target peak (Pa2) located in the first voltage section (S1) of the second differential profile BP"2 gradually decreases over time.

In addition, when the time point (t1) at which the second differential capacity value of the first target peak (Pa2) becomes smaller than the first threshold value (Qr"1) is reached, a peak splitting phenomenon occurs in the first target peak (Pa2).

FIG. 9 is a graph showing the change in the second differential capacity value of a second target peak (Pb2) according to the uneven deterioration of the battery bank.

As shown in FIG. 9, when the battery cells of the battery bank are deteriorated unevenly, the second differential capacity value of the second target peak (Pb2) located in the second voltage section (S2) of the second differential profile BP"2 gradually decreases over time.

In addition, when the time point (t2) at which the second differential capacity value of the second target peak (Pb2) becomes smaller than the second threshold value (Qr"2) occurs, a peak splitting phenomenon occurs in the second target peak (Pb2).

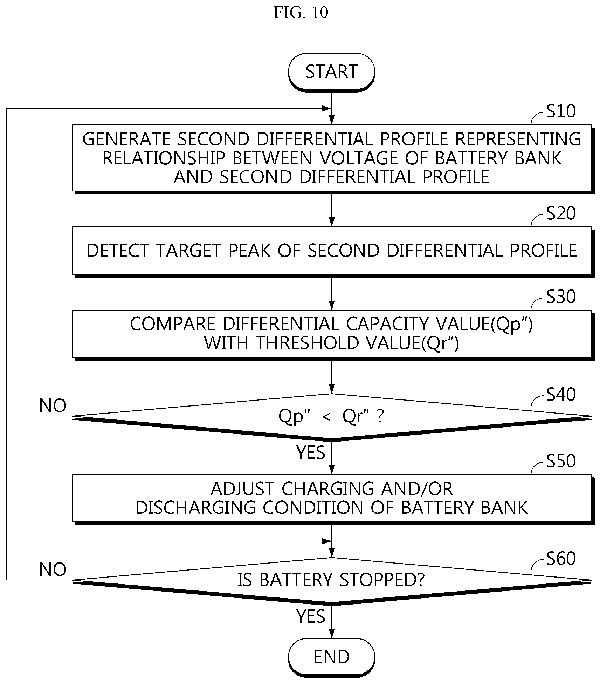

FIG. 10 is a flow chart showing a method for diagnosing a battery assembly according to an embodiment of the present disclosure.

As illustrated in FIG. 10, the method for diagnosing a battery assembly according to the present disclosure is a method for non-destructively diagnosing a battery assembly including a battery bank provided by connecting a plurality of battery cells in parallel with each other, and may be performed by a processor.

First, the processor generates a second differential profile representing the relationship between a second differential capacity, which is obtained by taking a second derivative of the capacity of the battery bank included in the battery assembly with respect to the voltage of the battery bank, and the voltage of the battery bank (S10).

In this case, the processor may repeatedly measure the voltage value and current value of the battery bank using at least one electrical sensor while the battery bank is being charged or discharged.

Then, the processor may generate the second differential profile using the voltage values and current values measured while the battery bank is being charged or discharged.

For example, the processor may generate a profile representing the relationship between the voltage and capacity of the battery bank using voltage values and current values measured while the battery bank is being charged or discharged.

Next, the processor may generate a first differential profile by differentiating the generated profile with respect to the voltage of the battery bank, and then generate the second differential profile by differentiating the first differential profile with respect to the voltage of the battery bank.

Next, the processor may diagnoses the state of the battery bank based on the second differential capacity value of the target peak located in a predetermined voltage section among a plurality of peaks of the second differential profile.

That is, the processor may detect a target peak located in the predetermined voltage section among the plurality of peaks of the second differential profile (S20).

The voltage section where the target peak is located may be experimentally determined. That is, the voltage section in which the peak where splitting occurs due to uneven deterioration of the battery bank among the peaks of the second differential profile is located may be experimentally confirmed, and the confirmed voltage section may be determined as the voltage section where the target peak is located.

Then, the processor may diagnose the state of the battery bank by comparing the second differential capacity value (Qp") of the target peak with a predetermined threshold value (Qr") (S30).

For example, the processor may diagnose the state of the battery bank as an abnormal state when the second differential capacity value (Qp") of the target peak is less than the threshold value (Qr") (S40). In this case, the abnormal state may mean a state in which the plurality of battery cells forming the battery bank are unevenly deteriorated.

The threshold value may be the minimum value among the second differential capacity values that the target peak of a normal battery bank may have, or a value determined during the design of the battery assembly.

In another embodiment, the processor may be configured to diagnose the state of the battery bank as an abnormal state if the second differential capacity value of the target peak is less than a predetermined threshold value and the number of peaks located in the predetermined voltage section exceeds a predetermined reference number. In this case, the abnormal state may mean a state in which the plurality of battery cells forming the battery bank are unevenly deteriorated.

In another embodiment, the processor may be configured to determine the state of the battery bank based on a plurality of target peaks.

In this case, the processor may be configured to detect a first target peak located in a first voltage section and a second target peak located in a second voltage section among predetermined voltage sections.

And, the processor may be configured to determine the state of the battery bank as an abnormal state if the second differential capacity value of the first target peak is less than a predetermined first threshold value and the second differential capacity value of the second target peak is less than a predetermined second threshold value. In this case, the abnormal state may mean a state in which the plurality of battery cells included in the battery bank are unevenly deteriorated.

In addition, in an embodiment, when the battery assembly to be diagnosed includes a plurality of battery banks, the processor may be configured to generate a plurality of second differential profiles respectively corresponding to the plurality of battery banks.

In this case, the processor may be configured to diagnose the state of each of the plurality of battery banks as a normal state or an abnormal state based on the plurality of second differential profiles.

Then, the processor may adjust the charging condition and/or discharging condition of the battery bank according to the diagnosis result for the battery bank (S50).

For example, when an abnormal battery bank diagnosed as an abnormal state is detected among the plurality of battery banks included in the battery assembly, the processor may be configured to control a charger that charges the abnormal battery bank to reduce a voltage at the end of charging of the abnormal battery bank or reduce a current rate of a current that charges the abnormal battery bank.

Also, the processor may be configured to control the cooling device 18 described later to lower the temperature of the abnormal battery bank.

Meanwhile, the processor may output a visual, auditory or audio-visual notification signal corresponding to the diagnosis result regarding the battery bank using a predetermined output device.

Then, the processor may repeat the steps described above (S10 to S50) until the battery assembly is no longer in use (S60).

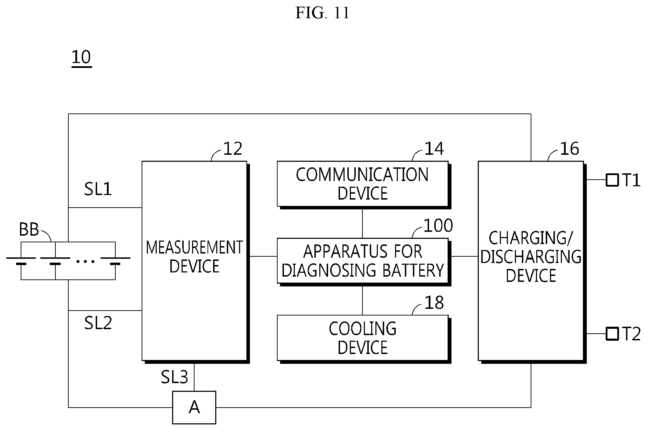

FIG. 11 is a drawing showing a battery pack 10 according to an embodiment of the present disclosure.

As illustrated in FIG. 11, the battery pack 10 includes a battery bank BB provided by connecting a plurality of battery cells in parallel with each other, and the apparatus 100 for diagnosing a battery according to the present disclosure. In an embodiment, the battery pack 10 may optionally further include a measurement device 12, a communication device 14, a charging/discharging device 16, and a cooling device 18.

The measurement device 12 may be configured to measure the voltage and/or current of the battery bank BB. To this end, the measurement device 12 may include at least one voltage sensor for sensing the voltage of the battery bank BB and/or at least one current sensor for sensing the current of the battery bank BB.

The measurement device 12 may measure the voltage of the battery bank BB through the first sensing line SL1 and the second sensing line SL2. In addition, the measurement device 12 may measure the current of the battery bank BB through the third sensing line SL3 connected to the current measurement circuit A. The current measurement circuit A may include a shunt resistor.

The apparatus 100 for diagnosing a battery assembly according to an embodiment of the present disclosure may obtain voltage values of the battery bank BB through the measurement device 12. For reference, the capacity of the battery bank BB may be calculated by applying the current integration method to the current charging battery bank BB.

The communication device 14 may be configured to perform communication with another device located remotely. For example, the communication device 14 may be configured to receive data transmitted from a remote server or communication terminal through a wired and/or wireless communication network and transmit the data to the apparatus 100 for diagnosing a battery assembly, or transmit data generated in the apparatus 100 for diagnosing a battery assembly to another server or communication terminal. To this end, the communication device 14 may include a communication modem that performs wired communication and/or wireless communication.

The charging/discharging device 16 may be configured to charge and/or discharge the battery bank BB. To this end, the charging/discharging device 16 may include a charger for charging the battery bank BB, a discharger for discharging the battery bank BB, at least one switch for electrically connecting the battery bank BB to terminals T1, T2 of the battery pack 10, etc.

The apparatus 100 for diagnosing a battery assembly according to an embodiment of the present disclosure may control the charging/discharging device 16 to perform or stop charging or discharging of the battery bank BB, set charging/discharging conditions, or change the set charging/discharging conditions.

The cooling device 18 may be configured to cool the battery bank BB. To this end, the cooling device 18 may include a heat sink that absorbs heat from the battery bank BB and releases it to the outside.

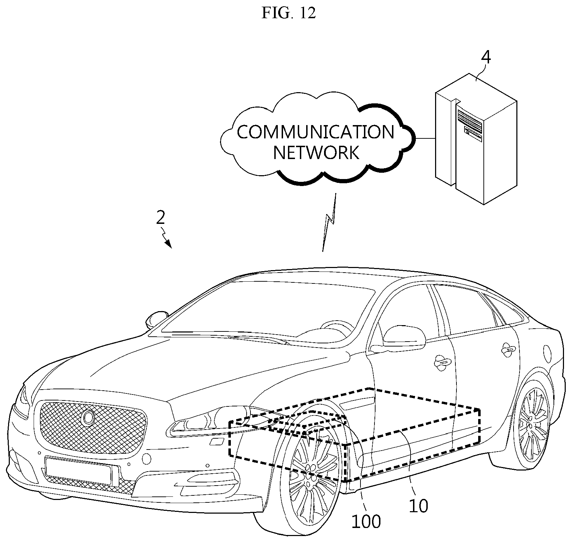

FIG. 12 is a drawing showing a vehicle according to an embodiment of the present disclosure.

As illustrated in FIG. 12, the vehicle 2 according to an embodiment of the present disclosure may include a battery pack 10 that provides electrical energy necessary for the operation of the vehicle and the apparatus 100 for diagnosing a battery according to the present disclosure.

In this case, the apparatus 100 for diagnosing a battery assembly may be configured to interact with an ECU (Electronic Control Unit) that controls the operation of the vehicle 2 or a BMS (Battery Management System) of the battery pack 10.

Additionally, the apparatus 100 for diagnosing a battery assembly may be configured to receive data transmitted from a remote server 4 via a wired and/or wireless communication network, or to transmit data generated by the apparatus 100 for diagnosing a battery to the server 4.

For reference, the apparatus 100 for diagnosing a battery assembly according to the present disclosure may be applied to various electrical devices or electrical systems other than vehicles, as well as to ESS (Energy Storage System).

As described above, embodiments of the present disclosure diagnose the state of the battery bank by using the second differential profile, which represents the relationship between the second differential capacity, which is obtained by taking a second derivative of the capacity of the battery bank included in the battery assembly with respect to the voltage of the battery bank, and the voltage of the battery bank, thereby enabling the diagnosis of the state of the battery assembly including a plurality of battery banks for each battery bank, and improving the accuracy and reliability of the diagnosis result.

In addition, embodiments of the present disclosure may be capable of accurately diagnosing whether the battery cells are deteriorated unevenly in a battery bank that is provided by connecting the battery cells in parallel with each other by diagnosing the state of the battery bank based on the second differential capacity value of a target peak located in a predetermined voltage section among a plurality of peaks of the second differential profile.

In addition, embodiments of the present disclosure may perform management of a battery assembly including a plurality of battery banks for each battery bank by controlling the charge and/or discharge conditions of the corresponding battery bank according to the diagnosis result of the battery bank, thereby extending the life of the entire battery assembly and improving safety.

Furthermore, the embodiments according to the present disclosure may solve various technical problems other than those mentioned in this specification in the corresponding technical field as well as in related technical fields.

### Explanation of reference signs

2: vehicle
10: battery pack
100: apparatus for diagnosing a battery
110: control unit
112: second differential profile generating unit
114: diagnosing unit
116: diagnosis result informing unit
118: battery management unit
120: communication unit
130: input unit
140: storage unit
150: output unit

## Claims

1. A method for diagnosing a battery assembly (BA) including a battery bank (BB1-BBn) comprising a plurality of battery cells (BC) connected in parallel with each other, the method comprising:
generating (S10) a second differential profile (BP"1, BP"2) representing a relationship between a second differential capacity (d²Q/dV²), which is obtained by taking a second derivative of a capacity (Q, SOC) of the battery bank (BB1-BBn) with respect to a voltage (V1-Vn) of the battery bank (BB1-BBn), and the voltage (V1-Vn) of the battery bank (BB1-BBn); and
detecting a target peak (Pa1, Pb1) located in a predetermined voltage section (S1, S2) among a plurality of peaks of the second differential profile (BP"1, BP"2) and
diagnosing (S30-S60) a state of the battery bank (BB1-BBn) based on a second differential capacity value (Qp") of the target peak (Pa1, Pb1).

2. The method for diagnosing the battery assembly (BA) according to claim 1,
wherein generating (S10) the second differential profile (BP"1, BP"2) includes:
repeatedly measuring a voltage value (V1-Vn) and a current value (I1) of the battery bank (BB1-BBn) using at least one electrical sensor while the battery bank (BB1-BBn) is being charged or discharged; and
generating the second differential profile (BP"1, BP"2) using the voltage values (V1-Vn) and the current values (I1) measured while the battery bank (BB1-BBn) is being charged or discharged.

3. The method for diagnosing the battery assembly (BA) according to claim 1 or 2,
wherein generating (S10) the second differential profile (BP"1, BP"2) includes;
generating a profile (BP) representing the relationship between the voltage (V1-Vn) and the capacity (Q, SOC) of the battery bank (BB1-BBn);
generating a first differential profile (BP'1, BP'2) by differentiating the profile (BP) with respect to the voltage (V1-Vn) of the battery bank (BB 1-BBn); and
generating the second differential profile (BP"1, BP"2) by differentiating the first differential profile (BP'1, BP'2) with respect to the voltage (V1-Vn) of the battery bank (BB1-BBn).

4. The method for diagnosing the battery assembly (BA) according to any one of the preceding claims,
wherein diagnosing (S30-S60) the state of the battery bank (BB1-BBn) includes
comparing (S30) the second differential capacity value (Qp") of the target peak (Pa1, Pb1) with a predetermined threshold value (Qr"), and
diagnosing (S40-S60) the state of the battery bank (BB1-BBn) as an abnormal state when the second differential capacity value (Qp") is less than the threshold value.

5. The method for diagnosing the battery assembly (BA) according to any one of the preceding claims,
wherein diagnosing (S30-S60) the state of the battery bank (BB1-BBn) includes
diagnosing (S40-S60) the state of the battery bank (BB1-BBn) as an abnormal state in which the plurality of battery cells (BC) are unevenly deteriorated, when the second differential capacity value (Qp") of the target peak (Pa1, Pb1) is less than a predetermined threshold value (Qr") and a number of peaks located in the predetermined voltage section (S1, S2) exceeds a predetermined reference number.

6. The method for diagnosing the battery assembly (BA) according to any one of the preceding claims,
wherein the battery assembly (BA) includes a plurality of battery banks (BB1-BBn), wherein the method further comprises
generating a plurality of second differential profiles (BP"1, BP"2) respectively corresponding to the plurality of battery banks (BB 1-BBn) included in the battery assembly (BA), and
diagnosing a state of each of the plurality of battery banks (BB1-BBn) as a normal state or an abnormal state based on the plurality of second differential profiles (BP"1, BP"2).

7. The method for diagnosing the battery assembly (BA) according to any one of the preceding claims,
wherein diagnosing the state of the battery bank (BB 1-BBn) includes diagnosing the state of the battery bank (BB1-BBn) as an abnormal state when the second differential capacity value (Qp") of the target peak (Pa1, Pb1) is less than a predetermined threshold value (Qr"), and
wherein the method for diagnosing a battery further comprises
controlling a charger that charges the battery bank (BB1-BBn) to reduce a voltage (V1-Vn) at an end of charging of the battery bank (BB1-BBn) or reduce a current rate of a current (I1) that charges the battery bank (BB1-BBn), when the state of the battery bank (BB1-BBn) is diagnosed as an abnormal state.

8. An apparatus (100) for diagnosing a battery assembly (BA) including a battery bank (BB1-BBn) comprising a plurality of battery cells (BC) connected in parallel with each other, the apparatus (100) comprising:
a second differential profile generating unit (112) configured to generate a second differential profile (BP"1, BP"2) representing a relationship between a second differential capacity (d²Q/dV²), which is obtained by taking a second derivative of a capacity (Q, SOC) of the battery bank (BB1-BBn) with respect to a voltage (V1-Vn) of the battery bank (BB1-BBn), and the voltage (V1-Vn) of the battery bank (BB1-BBn); and
a diagnosing unit (114) configured to detect a target peak (Pa1, Pb1) located in a predetermined voltage section (S1, S2) among a plurality of peaks of the second differential profile (BP"1, BP"2) and diagnose a state of the battery bank (BB1-BBn) based on a second differential capacity value (Qp") of the target peak (Pa1, Pb1).

9. The apparatus (100) for diagnosing the battery assembly (BA) according to claim 8,
wherein the diagnosing unit (114) is configured to compare the second differential capacity value (Qp") of the target peak (Pa1, Pb1) with a predetermined threshold value (Qr"), and diagnose the state of the battery bank (BB1-BBn) as an abnormal state when the second differential capacity value (Qp") is less than a threshold value.

10. The apparatus (100) for diagnosing the battery assembly (BA) according to claim 8 or 9,
wherein the diagnosing unit (114) is configured to diagnose the state of the battery bank (BB1-BBn) as an abnormal state in which the plurality of battery cells (BC) are unevenly deteriorated, when the second differential capacity value (Qp") of the target peak (Pa1, Pb1) is less than a predetermined threshold value (Qr") and a number of peaks located in the predetermined voltage section (S1, S2) exceeds a predetermined reference number.

11. The apparatus (100) for diagnosing the battery assembly (BA) according to any one of claims 8 to 10,
wherein the battery assembly (BA) includes a plurality of battery banks (BB1-BBn),
wherein the second differential profile generating unit (112) is configured to generate a plurality of second differential profiles (BP"1, BP"2) respectively corresponding to the plurality of battery banks (BB1-BBn) included in the battery assembly (BA), and
wherein the diagnosing unit (114) is configured to diagnose a state of each of the plurality of battery banks (BB1-BBn) as a normal state or an abnormal state based on the plurality of second differential profiles (BP"1, BP"2).

12. The apparatus (100) for diagnosing the battery assembly (BA) according to any one of claims 8 to 11,
wherein the diagnosing unit (114) is configured to diagnose the state of the battery bank (BB1-BBn) as an abnormal state when the second differential capacity value (Qp") of the target peak (Pa1, Pb1) is less than a predetermined threshold value (Qr"), and
wherein the apparatus (100) for diagnosing the battery further comprises a battery management unit (118) configured to control a charger that charges the battery bank (BB1-BBn) to reduce a voltage (V1-Vn) at an end of charging of the battery bank (BB1-BBn) or reduce a current rate of a current (I1) that charges the battery bank (BB1-BBn), when the state of the battery bank (BB1-BBn) is diagnosed as an abnormal state.

13. A battery pack (10) comprising the apparatus (100) for diagnosing the battery assembly (BA) according to any one of claims 8 to 12.

14. A vehicle (2) comprising the apparatus (100) for diagnosing the battery assembly (BA) according to any one of claims 8 to 12.

## Patentansprüche

1. Verfahren zum Diagnostizieren einer Batterieanordnung (BA), die eine Batteriebank (BB1-BBn) aufweist, welche mehrere Batteriezellen (BC) umfasst, die parallel geschaltet sind, wobei das Verfahren Folgendes umfasst:
Erzeugen (S10) eines zweiten Differenzprofils (BP"1, BP"2), das eine Beziehung zwischen einer zweiten Differenzkapazität (d²Q/dV²), die erhalten wird, indem eine zweite Ableitung einer Kapazität (Q, SOC) der Batteriebank (BB1-BBn) in Bezug auf eine Spannung (V1-Vn) der Batteriebank (BB1-BBn) genommen wird, und der Spannung (V1-Vn) der Batteriebank (BB1-BBn) darstellt; und
Detektieren eines Zielhöchstwertes (Pa1, Pb1), die sich in einem vorbestimmten Spannungsabschnitt (S1, S2) befindet, aus mehreren Höchstwerten des zweiten Differenzprofils (BP"1, BP"2), und
Diagnostizieren (S30-S60) eines Zustands der Batteriebank (BB1-BBn) basierend auf einem zweiten Differenzkapazitätswert (Qp") des Zielhöchstwertes (Pa1, Pb1).

2. Verfahren zum Diagnostizieren der Batterieanordnung (BA) nach Anspruch 1,
wobei das Erzeugen (S10) des zweiten Differenzprofils (BP"1, BP"2) Folgendes umfasst:
wiederholtes Messen eines Spannungswertes (V1-Vn) und eines Stromwertes (I1) der Batteriebank (BB1-BBn) unter Verwendung mindestens eines elektrischen Sensors, während die Batteriebank (BB1-BBn) geladen oder entladen wird; und
Erzeugen des zweiten Differenzprofils (BP"1, BP"2) unter Verwendung der Spannungswerte (V1-Vn) und der Stromwerte (I1) , die gemessen werden, während die Batteriebank (BB1-BBn) geladen oder entladen wird.

3. Verfahren zum Diagnostizieren der Batterieanordnung (BA) nach Anspruch 1 oder 2, wobei das Erzeugen (S10) des zweiten Differenzprofils (BP"1, BP"2) Folgendes umfasst:
Erzeugen eines Profils (BP), das die Beziehung zwischen der Spannung (V1-Vn) und der Kapazität (Q, SOC) der Batteriebank (BB1-BBn) darstellt;
Erzeugen eines ersten Differenzprofils (BP'1, BP'2) durch Differenzieren des Profils (BP) in Bezug auf die Spannung (V1-Vn) der Batteriebank (BB1-BBn); und
Erzeugen des zweiten Differenzprofils (BP"1, BP"2) durch Differenzieren des ersten Differenzprofils (BP'1, BP'2) in Bezug auf die Spannung (V1-Vn) der Batteriebank (BB1-BBn).

4. Verfahren zum Diagnostizieren der Batterieanordnung (BA) nach einem der vorhergehenden Ansprüche,
wobei das Diagnostizieren (S30-S60) des Zustands der Batteriebank (BB1-BBn) Folgendes umfasst:
Vergleichen (S30) des zweiten Differenzkapazitätswerts (Qp") des Zielhöchstwertes (Pa1, Pb1) mit einem vorbestimmten Schwellenwert (Qr"), und
Diagnostizieren (S40-S60) des Zustands der Batteriebank (BB1-BBn) als einen anormalen Zustand, wenn der zweite Differenzkapazitätswert (Qp") kleiner als der Schwellenwert ist.

5. Verfahren zum Diagnostizieren der Batterieanordnung (BA) nach einem der vorhergehenden Ansprüche,
wobei das Diagnostizieren (S30-S60) des Zustands der Batteriebank (BB1-BBn) Folgendes umfasst:
Diagnostizieren (S40-S60) des Zustands der Batteriebank (BB1-BBn) als einen anormalen Zustand, in dem sich die mehreren Batteriezellen (BC) ungleichmäßig verschlechtern, wenn der zweite Differenzkapazitätswert (Qp") des Zielhöchstwertes (Pa1, Pb1) kleiner als ein vorbestimmter Schwellenwert (Qr") ist und eine Anzahl von Höchstwerten, die sich in dem vorbestimmten Spannungsabschnitt (S1, S2) befinden, eine vorbestimmte Referenzanzahl überschreitet.

6. Verfahren zum Diagnostizieren der Batterieanordnung (BA) nach einem der vorhergehenden Ansprüche,
wobei die Batterieanordnung (BA) mehrere Batteriebänke (BB1-BBn) aufweist,
wobei das Verfahren ferner Folgendes umfasst:
Erzeugen mehrerer zweiter Differenzprofile (BP"1, BP"2), die jeweils den mehreren Batteriebänken (BB1-BBn) entsprechen, die in der Batterieanordnung (BA) enthalten sind, und
Diagnostizieren eines Zustands jeder der mehreren Batteriebänke (BB1-BBn) als einen normalen Zustand oder einen anormalen Zustand basierend auf den mehreren zweiten Differenzprofilen (BP"1, BP"2).

7. Verfahren zum Diagnostizieren der Batterieanordnung (BA) nach einem der vorhergehenden Ansprüche,
wobei das Diagnostizieren des Zustands der Batteriebank (BB1-BBn) das Diagnostizieren des Zustands der Batteriebank (BB1-BBn) als einen anormalen Zustand umfasst, wenn der zweite Differenzkapazitätswert (Qp") des Zielhöchstwertes (Pa1, Pb1) kleiner als ein vorbestimmter Schwellenwert (Qr") ist, und
wobei das Verfahren zum Diagnostizieren einer Batterie ferner Folgendes umfasst:
Steuern eines Ladegeräts, das die Batteriebank (BB1-BBn) lädt, um eine Spannung (V1-Vn) an einem Ende des Ladens der Batteriebank (BB1-BBn) zu reduzieren oder eine Stromrate eines Stromes (I1), der die Batteriebank (BB1-BBn) lädt, zu reduzieren, wenn der Zustand der Batteriebank (BB1-BBn) als ein anormaler Zustand diagnostiziert wird.

8. Vorrichtung (100) zum Diagnostizieren einer Batterieanordnung (BA), die eine Batteriebank (BB1-BBn) aufweist, die mehrere Batteriezellen (BC) umfasst, die parallel geschaltet sind, wobei die Vorrichtung (100) Folgendes aufweist:
eine zweite Differenzprofilerzeugungseinheit (112), die konfiguriert ist, um ein zweites Differenzprofil (BP"1, BP"2) zu erzeugen, das eine Beziehung zwischen einer zweiten Differenzkapazität (d²Q/dV²), die erhalten wird, indem eine zweite Ableitung einer Kapazität (Q, SOC) der Batteriebank (BB1-BBn) in Bezug auf eine Spannung (V1-Vn) der Batteriebank (BB1-BBn) genommen wird, und der Spannung (V1-Vn) der Batteriebank (BB1-BBn) darstellt; und
eine Diagnoseeinheit (114), die konfiguriert ist, um einen Zielhöchstwert (Pa1, Pb1), der sich in einem vorbestimmten Spannungsabschnitt (S1, S2) befindet, aus mehreren Höchstwerten des zweiten Differenzprofils (BP"1, BP"2) zu detektieren und einen Zustand der Batteriebank (BB1-BBn) basierend auf einem zweiten Differenzkapazitätswert (Qp") des Zielhöchstwertes (Pa1, Pb1) zu diagnostizieren.

9. Vorrichtung (100) zum Diagnostizieren der Batterieanordnung (BA) nach Anspruch 8,
wobei die Diagnoseeinheit (114) konfiguriert ist, um den zweiten Differenzkapazitätswert (Qp") des Zielhöchstwertes (Pa1, Pb1) mit einem vorbestimmten Schwellenwert (Qr") zu vergleichen und den Zustand der Batteriebank (BB1-BBn) als einen anormalen Zustand zu diagnostizieren, wenn der zweite Differenzkapazitätswert (Qp") kleiner als ein Schwellenwert ist.

10. Vorrichtung (100) zum Diagnostizieren der Batterieanordnung (BA) nach Anspruch 8 oder 9,
wobei die Diagnoseeinheit (114) konfiguriert ist, um den Zustand der Batteriebank (BB1-BBn) als einen anormalen Zustand zu diagnostizieren, in dem sich die mehreren Batteriezellen (BC) ungleichmäßig verschlechtern, wenn der zweite Differenzkapazitätswert (Qp") des Zielhöchstwertes (Pa1, Pb1) kleiner als ein vorbestimmter Schwellenwert (Qr") ist und eine Anzahl von Höchstwerten, die sich in dem vorbestimmten Spannungsabschnitt (S1, S2) befinden, eine vorbestimmte Referenzanzahl überschreitet.

11. Vorrichtung (100) zum Diagnostizieren der Batterieanordnung (BA) nach einem der Ansprüche 8 bis 10,
wobei die Batterieanordnung (BA) mehrere Batteriebänke (BB1-BBn) aufweist,
wobei die zweite Differenzprofilerzeugungseinheit (112) konfiguriert ist, um mehrere zweite Differenzprofile (BP"1, BP"2) zu erzeugen, die jeweils den mehreren Batteriebänken (BB1-BBn) entsprechen, die in der Batterieanordnung (BA) enthalten sind, und
wobei die Diagnoseeinheit (114) konfiguriert ist, um einen Zustand jeder der mehreren Batteriebänke (BB1-BBn) als einen normalen Zustand oder einen anormalen Zustand basierend auf den mehreren zweiten Differenzprofilen (BP"1, BP"2) zu diagnostizieren.

12. Vorrichtung (100) zum Diagnostizieren der Batterieanordnung (BA) nach einem der Ansprüche 8 bis 11,
wobei die Diagnoseeinheit (114) konfiguriert ist, um den Zustand der Batteriebank (BB1-BBn) als einen anormalen Zustand zu diagnostizieren, wenn der zweite Differenzkapazitätswert (Qp") des Zielhöchstwertes (Pa1, Pb1) kleiner als ein vorbestimmter Schwellenwert (Qr") ist, und
wobei die Vorrichtung (100) zum Diagnostizieren der Batterie ferner eine Batterieverwaltungseinheit (118) umfasst, die konfiguriert ist, um ein Ladegerät, das die Batteriebank (BB1-BBn) lädt, zu steuern, um eine Spannung (V1-Vn) an einem Ende des Ladens der Batteriebank (BB1-BBn) zu reduzieren oder eine Stromrate eines Stromes (I1), der die Batteriebank (BB1-BBn) lädt, zu reduzieren, wenn der Zustand der Batteriebank (BB1-BBn) als ein anormaler Zustand diagnostiziert wird.

13. Batteriepack (10), umfassend die Vorrichtung (100) zum Diagnostizieren der Batterieanordnung (BA) nach einem der Ansprüche 8 bis 12.

14. Fahrzeug (2), umfassend die Vorrichtung (100) zum Diagnostizieren der Batterieanordnung (BA) nach einem der Ansprüche 8 bis 12.

## Revendications

1. Procédé pour diagnostiquer un ensemble de batteries (BA) incluant un banc de batteries (BB1-BBn) comprenant une pluralité de cellules de batterie (BC) connectées entre elles en parallèle, le procédé comprenant :
la génération (S10) d'un deuxième profil différentiel (BP"1, BP"2) représentant une relation entre une deuxième capacité différentielle (d²Q/dV²) obtenue en prenant une deuxième dérivée d'une capacité (Q, SOC) du banc de batteries (BB1-BBn) relativement à une tension (V1-Vn) du banc de batteries (BB1-BBn), et la tension (V1-Vn) du banc de batteries (BB1-BBn) ; et
la détection d'un pic cible (Pa1, Pb1) situé dans une section de tension prédéterminée (S1, S2) parmi une pluralité de pics du deuxième profil différentiel (BP"1, BP"2) et
le diagnostic (S30-S60) d'un état du banc de batteries (BB1-BBn) d'après une deuxième valeur de capacité différentielle (Qp") du pic cible (Pa1, Pb1).

2. Procédé de diagnostic de l'ensemble de batteries (BA) selon la revendication 1,
la génération (S10) du deuxième profil différentiel (BP"1, BP"2) comprenant :
la mesure à plusieurs reprises d'une valeur de tension (V1-Vn) et d'une valeur de courant (I1) du banc de batteries (BB1-BBn) à l'aide d'au moins un capteur électrique au cours de la charge ou la décharge du banc de batteries (BB1-BBn) ; et
la génération du deuxième profil différentiel (BP"1, BP"2) en utilisant les valeurs de tension (V1-Vn) et les valeurs de courant (I1) mesurées au cours de la charge ou de la décharge du banc de batteries (BB1-BBn).

3. Procédé de diagnostic de l'ensemble de batteries (BA) selon la revendication 1 ou 2, la génération (S10) du deuxième profil différentiel (BP"1, BP"2) comprenant :
la génération d'un profil (BP) représentant la relation entre la tension (V1-Vn) et la capacité (Q, SOC) du banc de batteries (BB1-BBn) ;
la génération d'un premier profil différentiel (BP'1, BP'2) en différenciant le profil (BP) relativement à la tension (V1-Vn) du banc de batteries (BB1-BBn) ; et
la génération d'un deuxième profil différentiel (BP'1, BP'2) en différenciant le premier profil différentiel (BP'1, BP'2) relativement à la tension (V1-Vn) du banc de batteries (BB1-BBn).

4. Procédé de diagnostic de l'ensemble de batteries (BA) selon une quelconque des revendications précédentes,
le diagnostic (S30-S60) de l'état du banc de batteries (BB1-BBn) comprenant
la comparaison (S30) de la deuxième valeur de capacité différentielle (Qp") du pic cible (Pa1, Pb1) avec une valeur seuil prédéterminée (Qr"), et
le diagnostic (S40-S60) l'état du banc de batteries (BB1-BBn) comme étant dans un état anormal lorsque la deuxième valeur de capacité différentielle (Qp") est inférieure à la valeur seuil.

5. Procédé de diagnostic de l'ensemble de batteries (BA) selon une quelconque des revendications précédentes,
le diagnostic (S30-S60) de l'état du banc de batteries (BB1-BBn) comprenant
le diagnostic (S40-S60) de l'état du banc de batteries (BB1-BBn) comme étant dans un état anormal dans lequel la pluralité de cellules de batterie (BC) sont détériorées de manière irrégulière, lorsque la deuxième valeur de capacité différentielle (Qp") du pic cible (Pa1, Pb1) est inférieure à une valeur seuil prédéterminée (Qr") et un nombre de pics localisés dans la section de tension prédéterminée (S1, S2) dépasse un nombre de référence prédéterminé.

6. Procédé de diagnostic de l'ensemble de batteries (BA) selon une quelconque des revendications précédentes,
l'ensemble de batteries (BA) comprenant une pluralité de bancs de batteries (BB1-BBn),
le procédé comprenant en outre
la génération d'une pluralité de deuxièmes profils différentiels (BP"1, BP"2) correspondant respectivement à la pluralité de bancs de batteries (BB1-BBn) inclus dans l'ensemble de batteries (BA), et
le diagnostic d'un état de chacun de la pluralité de bancs de batteries (BB1-BBn) comme étant un état normal ou un état anormal d'après la pluralité de deuxièmes profils différentiels (BP"1, BP"2).

7. Procédé de diagnostic de l'ensemble de batteries (BA) selon une quelconque des revendications précédentes,
le diagnostic de l'état du banc de batteries (BB1-BBn) comprenant le diagnostic de l'état du banc de batteries (BB1-BBn) comme étant un état anormal lorsque la deuxième valeur de capacité différentielle (Qp") du pic cible (Pa1, Pb1) est inférieure à une valeur seuil prédéterminée (Qr"), et
le procédé de diagnostic d'une batterie comprenant en outre
le contrôle d'un chargeur chargeant le banc de batteries (BB1-BBn) pour réduire une tension (V1-Vn) à la fin de la charge du banc de batteries (BB1-BBn) ou réduire un régime (I1) chargeant le banc de batteries (BB1-BBn), lorsque l'état du banc de batteries (BB1-BBn) est diagnostiqué comme étant anormal.

8. Appareil (100) de diagnostic d'un ensemble de batteries (BA) comprenant un banc de batteries (BB1-BBn) comprenant une pluralité de cellules de batterie (BC) connectées entre elles en parallèle, l'appareil (100) comprenant :
un dispositif de génération d'un deuxième profil différentiel (112) configuré pour produire un deuxième profil différentiel (BP"1, BP"2) représentant une relation entre une deuxième capacité différentielle (d²Q/dV²), obtenue en prenant une deuxième dérivée d'une capacité (Q, SOC) du banc de batteries (BB1-BBn) relativement à une tension (V1-Vn) du banc de batteries (BB1-BBn), et la tension (V1-Vn) du banc de batteries (BB1-BBn) ; et
un dispositif de diagnostic (114) configuré pour détecter un pic cible (Pa1, Pb1) situé dans une section de tension prédéterminée (S1, S2) parmi une pluralité de pics du deuxième profil différentiel (BP"1, BP"2) et diagnostiquer un état du banc de batteries (BB1-BBn) d'après une deuxième valeur de capacité différentielle (Qp") du pic cible (Pa1, Pb1).

9. Appareil (100) de diagnostic de l'ensemble de batteries (BA) selon la revendication 8,
le dispositif de diagnostic (114) étant configuré pour comparer la deuxième valeur de capacité différentielle (Qp") du pic cible (Pa1, Pb1) et une valeur seuil prédéterminée (Qr"), et diagnostiquer l'état du banc de batteries (BB1-BBn) comme un état anormal lorsque la deuxième valeur de capacité différentielle (Qp") est inférieure à une valeur seuil.

10. Appareil (100) de diagnostic de l'ensemble de batteries (BA) selon la revendication 8 ou 9,
le dispositif de diagnostic (114) étant configuré pour diagnostiquer l'état du banc de batteries (BB1-BBn) comme étant dans un état anormal dans lequel la pluralité de cellules de batterie (BC) sont détériorées de manière irrégulière, lorsque la deuxième valeur de capacité différentielle (Qp") du pic cible (Pa1, Pb1) est inférieure à une valeur seuil prédéterminée (Qr") et un nombre de pics localisés dans la section de tension prédéterminée (S1, S2) est supérieur à un nombre de référence prédéterminé.

11. Appareil (100) de diagnostic de l'ensemble de batteries (BA) selon une quelconque des revendications 8 à 10,
l'ensemble de batteries (BA) comprenant une pluralité de bancs de batteries (BB1-BBn),
le dispositif de génération d'un deuxième profil différentiel (112) étant configuré pour générer une pluralité de deuxièmes profils différentiels (BP"1, BP"2) correspondant respectivement à la pluralité de bancs de batteries (BB1-BBn) inclus dans l'ensemble de batteries (BA), et
le dispositif de diagnostic (114) étant configuré pour diagnostiquer un état de chacun de la pluralité de bancs de batteries (BB1-BBn) comme étant un état normal ou un état anormal d'après la pluralité de deuxièmes profils différentiels (BP"1, BP"2).

12. Appareil (100) de diagnostic de l'ensemble de batteries (BA) selon une quelconque des revendications 8 à 11,
le dispositif de diagnostic (114) étant configuré pour diagnostiquer l'état du banc de batteries (BB1-BBn) comme étant un état anormal lorsque la deuxième valeur de capacité différentielle (Qp") du pic cible (Pb1, Pb1) est inférieure à une valeur seuil prédéterminée (Qr"), et
l'appareil (100) de diagnostic de la batterie comprenant en outre un module de gestion de batterie (118) configuré pour gérer un chargeur chargeant le banc de batteries (BB1-BBn) pour réduire une tension (V1-Vn) en fin de charge du banc de batteries (BB1-BBn), ou réduire un régime d'un courant (l1) chargeant le banc de batteries (BB1-BBn), lorsque le banc de batteries (BB1-BBn) est diagnostiqué comme étant dans un état anormal.

13. Bloc-batterie (10) comprenant l'appareil (100) de diagnostic de l'ensemble de batteries (BA) selon une quelconque des revendications 8 à 12.

14. Véhicule (2) comprenant l'appareil (100) de diagnostic de l'ensemble de batteries (BA) selon une quelconque des revendications 8 à 12.
